# EUROPEAN PATENT APPLICATION

(11) **EP 4 632 787 A1**
(43) Date of publication of application: **15.10.2025**
(21) Application number: 24169353.0
(22) Date of filing: 10.04.2024
(51) Int. Cl.: H01J 37/22, H01J 37/244, H01J 37/26, H01J 37/28

(54) **METHOD FOR OBTAINING A TILT SERIES OF IMAGES OF A SAMPLE AT A PLURALITY OF TILT ANGLES**

(71) Applicant: FEI COMPANY, Hillsboro, OR 97124 (US)
(72) Inventor: KOHR, Holger, Eindhoven (NL); FRANKEN, Erik, Nuenen (NL)
(74) Representative: Janssen, Francis-Paul

(57) **Abstract**

A method and charged particle microscope for obtaining a tilt series of images based on exposure of a region of interest of a sample to a charged particle beam at a plurality of tilt angles. The method comprises the step of tracking a field of view (FOV) during the step of obtaining the tilt series of images. The method comprises the step of producing a tomographic image of a sample volume related to said region of interest based on at least some images of the obtained tilt series. As defined herein, the step of tracking the field of view (FOV) comprises the step of exposing a tracking region that is substantially outside of said region of interest (ROI). The charged particle microscope as defined herein is arranged for performing the method as defined herein.

## Description

The present invention relates to a method and a charged particle microscope for obtaining a tilt series of images based on exposure of a region of interest (ROI) of a sample to a charged particle beam (CPB) at a plurality of tilt angles. More specifically, it pertains to a system that utilizes a charged particle optical column, a sample holder, a charged particle detector, and an imaging system to generate detailed images of samples for acquiring said tilt series of images.

In various scientific and industrial applications, it is often necessary to examine the microscopic structure and composition of samples. Traditional optical microscopes have limitations in resolution and are unable to provide sufficient detail for certain types of samples. To overcome these limitations, charged particle microscopes have been developed.

Charged particle microscopy is a well-known and increasingly important technique for imaging microscopic objects, particularly in the form of electron microscopy. Historically, the basic genus of electron microscope has undergone evolution into a number of well-known apparatus species, such as the Transmission Electron Microscope (TEM), Scanning Electron Microscope (SEM), and Scanning Transmission Electron Microscope (STEM), and also into various sub-species, such as a so-called "dual-beam" apparatus (*e.g.* a FIB-SEM) that additionally employs a Focused Ion Beam (FIB), allowing supportive activities such as ion-beam milling or lon-Beam-Induced Deposition (IBID). The skilled person will be familiar with the different species of charged particle microscopy.

These charged particle microscopes generally comprise several components, which will be explained below.

Firstly, a charged particle microscope comprises a charged particle optical column that is employed to direct a charged particle beam onto the sample. This optical column is responsible for directing and controlling the charged particles to the sample to ensure accurate imaging.

Additionally, the charged particle microscope comprises a sample holder for securely holding a sample in place during the imaging process. The sample holder is generally designed to accommodate various sample sizes and shapes, providing stability and reproducibility in positioning.

Furthermore, the charged particle microscope comprises a charged particle detector to capture charged particles that interact with the sample. The charged particle detector converts the energy or intensity of the charged particles into electrical signals, which can be further processed for image generation.

The charged particle microscope also includes an imaging system that is arranged for processing signals from the charged particle detector. The imaging system receives data from the charged particle detector and generates an image signal based on the collected information.

Transmission electron microscopes (TEMs) can be used to obtain high resolution images that reveal important details of many kinds of samples, including biological samples. In electron beam tomography, multiple images of a sample are needed for image reconstruction.

Typically, in tomography, tracking the field-of-view (FOV) is a time-consuming process. There are two main methods of tracking: 'tracking after', where images that have already been captured are used, and 'tracking before', where images are captured at a nearby area before the main acquisition. However, both these methods have their drawbacks. 'Tracking after' can fail due to low signal-noise ratio (SNR) caused by low dose typically used for acquiring the main images. 'Tracking before' is more reliable as a higher dose can be used, but adds significant time to the process.

In a specific method of tomography called fast-incremental single-exposure (FISE) acquisition, the camera is always on, and there's no chance for tracking at all. This method assumes that the area of interest will remain in the FOV, which can be difficult or even impossible due to inevitable specimen stage moves while tilting. This FISE acquisition method is described in further detail in "Rapid tilt-series acquisition for electron cryotomography. Journal of Structural Biology. 2019 Feb 1;205(2):163-169.

It is thus an object of the disclosure to provide an improved method, in particular a method that improves the tracking of the field of view in tilt series acquisitions.

To this end, the disclosure provides a method as described in claim 1. The method as defined herein includes obtaining a tilt series of images based on exposure of a region of interest (ROI) of a sample to a charged particle beam (CPB) at a plurality of tilt angles. Additionally, the method involves tracking a field of view (FOV).

The step of tracking the field of view (FOV) is performed during the step of obtaining the tilt series of images and comprises exposing a tracking region that is substantially outside of the region of interest (ROI). This ensures that the tracking process does not interfere with the imaging of the ROI, leading to less damage for the ROI and more accurate tomographic image reconstruction. Also, by using a tracking region outside of the region of interest, it is possible to track the field of view during the acquisition of the tilt series images (in particular during the actual step of tilting the sample), leading to faster acquisition times for the tilt series with improved accuracy in view of the ability to track the field of view during the acquisition.

As defined herein, the method provides an improved way of tracking the field of view by exposing a tracking region. The tracking region is substantially different from said region of interest. The tracking region allows for a continuous (or semi-continuous) way of tracking the field of view during the acquisition of the tilt series images. The information coming from this tracking region (which can be images, for example) can be processed and used to ensure that the region of interest stays in the field of view.

With this, an improved method of acquiring a tilt series is obtained, which provides improvements over "before-tracking" and "after-tracking", as it allows for accurate tracking of the field of view during the imaging process. With this, the objective of the disclosure is achieved.

Advantageous embodiments will be discussed below.

In an embodiment, the method comprises the step of deflecting said charged particle beam between said region of interest and said tracking region. By deflecting between the two regions it is possible to track the field of view, whilst reducing the exposure to the region of interest. This way dose control is applied to the region of interest.

In an embodiment, the ratio between exposure of the region of interest and exposure of the tracking region is in between 1:2 to 1:10, more in particular around 1:4. In other words, for a ratio of 1:4, exposure of the region of interest may be 20% of the time, and exposure of the tracking region may be 80% of the time. Thus, during acquisition of a tilt series the charged particle beam is directed to the region of interest for 20% of the time to gather images of the region of interest, and for 80% of the time the charged particle beam is exposing the tracking region to enable the tilt angle to reach a next position where the region of interest can be imaged, once again.

In an embodiment, said tracking region is completely separate from said region of interest. In other words, there is no overlap between the tracking region and the region of interest. This further aids in protecting the region of interest.

In an embodiment, the method includes using images of the tracking region for determining a shift in the field of view of the region of interest.

In an embodiment, the method involves using the field of view of the tracking region for providing a feedback loop during the step of obtaining the tilt series of images of the region of interest. This feedback loop helps to continuously adjust and optimize the imaging process, resulting in improved image quality. The feedback loop allows for reliable tracking of the FOV without substantially adding overhead time. The feedback loop may be used in the step of tilting the sample to a next acquisition angle.

In an embodiment, the method includes using a blanker for at least partly preventing exposure to the region of interest during the step of exposing the tracking region. A (fast) blanker may be used for dose control of the region of interest. A fast deflector may be used for toggling between the region of interest and the tracking region. The blanker can be applied as an on/off-switch, with predetermined duty cycle, for example.

In an embodiment, the method involves correcting the field of view by moving the sample relative to the charged particle beam. This correction allows for precise alignment and positioning of the FOV, ensuring accurate tomographic image reconstruction.

In an embodiment, the method can be applied to both step-by-step tomography and continuous tilt tomography. This versatility allows for the method to be utilized in various imaging techniques, providing flexibility in experimental setups.

In an embodiment, the method includes producing a tomographic image of a sample volume related to the region of interest based on at least some images of the obtained tilt series.

According to an aspect, a charged particle microscope as defined in claim 1 is provided. The charged particle microscope as defined herein includes a charged particle optical column for directing a charged particle beam onto a sample, a sample holder for holding a sample, and a charged particle detector and an imaging system for generating an image signal based on information from the charged particle detector. Additionally, the charged particle microscope is arranged for obtaining a tilt series of images based on exposure of a region of interest (ROI) of a sample to the charged particle beam (CPB) at a plurality of tilt angles. Furthermore, the charged particle microscope is arranged for tracking a field of view (FOV). The charged particle microscope may be arranged for, or be part of a system that is arranged for, producing a tomographic image of a sample volume related to said region of interest based on at least some images of the obtained tilt series.

As defined herein, the charged particle microscope M is arranged for tracking the field of view (FOV) during the step of obtaining the tilt series of images by exposing a tracking region that is substantially outside of said region of interest (ROI). An advantage of this arrangement is that it allows for integrated tracking and imaging capabilities within the microscope system. The tracking of the field of view using the tracking region allows for tracking during acquisition of the tilt series (i.e. during the step of tilting the sample), without substantially damaging the region of interest. Based on the data emanating from the tracking region, optimal stage settling time based on measured drift can be determined, and eucentric offset can be detected and corrected, and it may allow for pre-alignment and live image analysis.

In an embodiment, the charged particle microscope is arranged for tracking the field of view (FOV) by exposing a tracking region that is substantially outside of the region of interest (ROI). This arrangement ensures accurate tracking of the FOV without interfering with the imaging process of the ROI.

In an embodiment, the charged particle microscope is arranged for performing any of the embodiments of the method as disclosed herein.

For providing real-time feedback to the microscope, the imaging system of the charged particle microscope may have a first charged particle detector output interface for outputting a first data stream of data related to said charged particle detector, as well as a second charged particle detector output interface for outputting a second data stream of data related to said charged particle detector. These two charged particle detector output interfaces can be used for providing real-time feedback (from one output interface) while maintaining high data quality and reliability (from the other output interface). By having two charged particle detector output interfaces that are arranged for providing different data steams compared to each other, the system allows to have two separate data streams that can be used for different purposes.

As an example, the first data stream may be designed to prioritize data quality and reliability, ensuring accurate and dependable data output. Thus, the first data stream can be optimized for a high image quality standard that allows for producing the tomographic image of the sample volume related to said region of interest based on at least some images of the obtained tilt series.

The second data stream may be designed to be optimized for low latency and/or fixed latency. This allows for images of the tracking region to be obtained and used for providing real-time feedback to the charged particle system. The real-time feedback can be used for providing a relative adjustment between the sample and the charged particle beam, for example by means of a stage movement and/or a deflection of the charged particle beam.

As defined herein, latency relates to the time difference between the moment a charged particle hits the charged particle detector (i.e. charged particle camera) and the moment the information from that charged particle is ready to be used by any device that is positioned downstream of the output interface. An example of such a device that is/can be positioned downstream of the output interface, is given by a data storage, a feedback processing device, a controller, etcetera. Latency can relate to the average time difference or the maximum time difference.

In an embodiment that is suitable for charged particle microscopy, the latency is in the order of half the readout integration time of the charged particle detector. If the charged particle detector, which can be a TEM camera, for example, runs at 500 frames per second (fps), every pixel readout takes 2 ms. Low latency means that the time it takes for the data to come from the charged particle detector and be output through said second output interface (after which it can be used by a further processing device, for example) is in the order of the pixel readout too. This means that the low latency should be in the order of ms. Based on this example, the average latency can be about 1 ms, and the maximum latency can be about 2 ms. Higher latency, even though not optimal, can still give beneficial effects for providing real-time feedback.

As indicated above, the maximum low latency output can be related to the frame rate of the charged particle detector. For a frame rate of 500 fps, the maximum low latency is preferably in the order of 1/500 = 2 ms. For a lower frame rate (e.g. 250 fps) the maximum low latency can be 1/250 = 4 ms.

As indicated above, the average low latency output can be related to the frame rate of the charged particle detector. For a frame rate of 500 fps, the average low latency is preferably in the order of 0.5*1/500 = 1 ms. For a lower frame rate (e.g. 250 fps) the average low latency can be 0.5*1/250 = 2 ms.

This average and/or maximum latency can be used for providing real-time feedback to the charged particle microscope, with which the field of view can be accurately tracked during acquisition of the tilt series.

In an embodiment, the charged particle microscope is part of a system that is arranged for producing a tomographic image of a sample volume related to the region of interest based on at least some images of the obtained tilt series.

### Brief description of the drawings

For a more thorough understanding of the present disclosure, and advantages thereof, reference is now made to the following descriptions taken in conjunction with the accompanying drawings, in which:
Fig. 1 shows a longitudinal cross-sectional view of a charged particle microscope, in particular a transmission charged particle microscope;
Fig. 2 shows an embodiment of a charged particle microscope as defined herein;
Fig. 3 shows a further embodiment of a charged particle microscope as defined herein;
Fig. 4 shows yet a further embodiment of a charged particle microscope as defined herein;
Fig. 5a and 5b show a region of interest and tracking area of a sample in an embodiment of the method as disclosed herein;
Fig. 6a and 6b show a region of interest and tracking area of a sample in an embodiment of the method as disclosed herein;
Fig. 7a and 7b show an embodiment of the deflector and blanker signals during acquisition, and during tilting, respectively.
Fig. 8 shows an embodiment of the deflector and blanker signals during tilting.

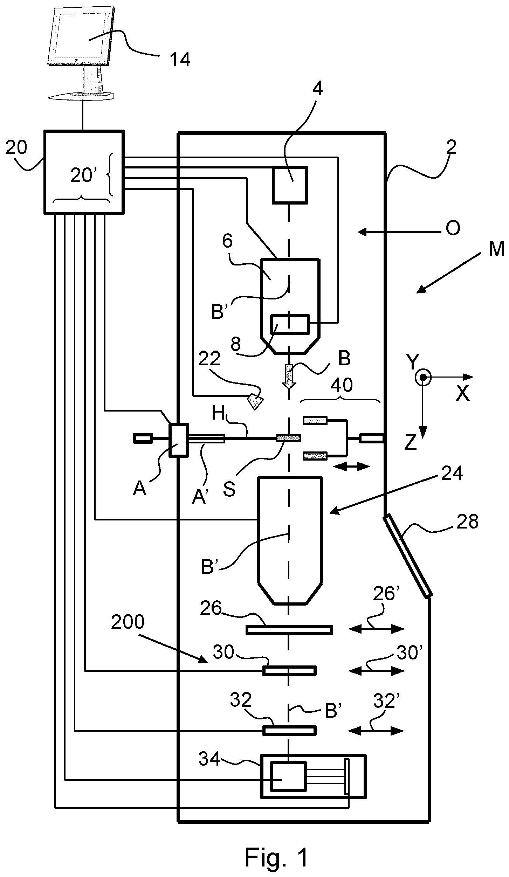

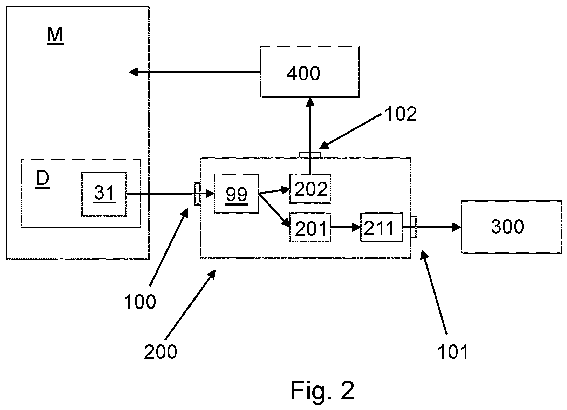

Fig. 1 (not to scale) is a highly schematic depiction of an embodiment of a charged-particle microscope M according to an embodiment of the invention. More specifically, it shows an embodiment of a transmission-type microscope M, which, in this case, is a TEM/STEM (though, in the context of the current invention, it could just as validly be a SEM (see Figure 2), or an ion-based microscope, for example). In Fig. 1, within a vacuum enclosure 2, an electron source 4 produces a beam B of electrons that propagates along an electron-optical axis B' and traverses an electron-optical illuminator 6, serving to direct/focus the electrons onto a chosen part of a sample S (which may, for example, be (locally) thinned/planarized). Also depicted is a deflector 8, which (*inter alia*) can be used to effect scanning motion of the beam B.

The sample S is held on a sample holder H that can be positioned in multiple degrees of freedom by a positioning device / stage A, which moves a cradle A' into which holder H is (removably) affixed; for example, the sample holder H may comprise a finger that can be moved (*inter alia*) in the XY plane (see the depicted Cartesian coordinate system; typically, motion parallel to Z and tilt about X/Y will also be possible). Such movement allows different parts of the sample S to be illuminated / imaged / inspected by the electron beam B traveling along axis B' (in the Z direction) (and/or allows scanning motion to be performed, as an alternative to beam scanning). If desired, an optional cooling device (not depicted) can be brought into intimate thermal contact with the sample holder H, so as to maintain it (and the sample S thereupon) at cryogenic temperatures, for example.

The electron beam B will interact with the sample S in such a manner as to cause various types of "stimulated" radiation to emanate from the sample S, including (for example) secondary electrons, backscattered electrons, X-rays and optical radiation (cathodoluminescence). If desired, one or more of these radiation types can be detected with the aid of analysis device 22, which might be a combined scintillator/photomultiplier or EDX (Energy-Dispersive X-Ray Spectroscopy) module, for instance; in such a case, an image could be constructed using basically the same principle as in a SEM. However, alternatively or supplementally, one can study electrons that traverse (pass through) the sample S, exit/emanate from it and continue to propagate (substantially, though generally with some deflection/scattering) along axis B'. Such a transmitted electron flux enters a projection system (projection lens 24), which will generally comprise a variety of electrostatic / magnetic lenses, deflectors, correctors (such as stigmators), *etc.* In normal (non-scanning) TEM mode, this projection system 24 can focus the transmitted electron flux onto a fluorescent screen 26, which, if desired, can be retracted/withdrawn (as schematically indicated by arrows 26') so as to get it out of the way of axis B'. An image (or diffractogram) of (part of ) the sample S will be formed by projection system 24 on screen 26, and this may be viewed through viewing port 28 located in a suitable part of a wall of enclosure 2. The retraction mechanism for screen 26 may, for example, be mechanical and/or electrical in nature, and is not depicted here.

As an alternative to viewing an image on screen 26, one can instead make use of the fact that the depth of focus of the electron flux leaving projection system 24 is generally quite large (*e.g.* of the order of 1 meter). Consequently, various other types of analysis apparatus can be used downstream of screen 26, such as:
- TEM detector (camera) 30. At camera 30, the electron flux can form a static image (or diffractogram) that can be processed by controller/processor 20 and displayed on a display device (not depicted), such as a flat panel display, for example. When not required, camera 30 can be retracted/withdrawn (as schematically indicated by arrows 30') so as to get it out of the way of axis B'.
- STEM detector (camera) 32. An output from camera 32 can be recorded as a function of (X,Y) scanning position of the beam B on the sample S, and an image can be constructed that is a "map" of output from camera 32 as a function of X,Y. Camera 32 can comprise a single pixel with a diameter of *e.g*. 20 mm, as opposed to the matrix of pixels characteristically present in camera 30. Moreover, camera 32 will generally have a much higher acquisition rate (*e.g.* 10⁶ points per second) than camera 30 (*e.g.* 10² images per second). Once again, when not required, camera 32 can be retracted/withdrawn (as schematically indicated by arrows 32') so as to get it out of the way of axis B' (although such retraction would not be a necessity in the case of a donut-shaped annular dark field camera 32, for example; in such a camera, a central hole would allow flux passage when the camera was not in use).
- As an alternative to imaging using cameras 30 or 32, one can also invoke spectroscopic detector 34, which could be an EELS module, for example.

It should be noted that the order/location of items 30, 32 and 34 is not strict, and many possible variations are conceivable. For example, spectroscopic detector 34 can also be integrated into the projection system 24.

In the embodiment shown, the microscope M further comprises a retractable X-ray Computed Tomography (CT) module, generally indicated by reference 40. In Computed Tomography (also referred to as tomographic imaging) the source and (diametrically opposed) detector are used to look through the sample along different lines of sight, so as to acquire penetrative observations of the sample from a variety of perspectives.

Note that the detectors 30,32, 34 are part of an imaging system (generally indicated with reference sign 200). The imaging system is arranged for generating an image signal based on information from the charged particle detector 30, 32, 34, and can be part of that detector or be a separate part from that detector. The controller (computer processor) 20 is connected to various illustrated components *via* control lines (buses) 20'. This controller 20 can provide a variety of functions, such as synchronizing actions, providing setpoints, processing signals, performing calculations, and displaying messages/information on a display device (not depicted). Needless to say, the (schematically depicted) controller 20 may be (partially) inside or outside the enclosure 2, and may have a unitary or composite structure, as desired.

The skilled artisan will understand that the interior of the enclosure 2 does not have to be kept at a strict vacuum; for example, in a so-called "Environmental TEM/STEM", a background atmosphere of a given gas is deliberately introduced / maintained within the enclosure 2. The skilled artisan will also understand that, in practice, it may be advantageous to confine the volume of enclosure 2 so that, where possible, it essentially hugs the axis B', taking the form of a small tube (e.g. of the order of 1 cm in diameter) through which the employed electron beam passes, but widening out to accommodate structures such as the source 4, sample holder H, screen 26, camera 30, camera 32, spectroscopic detector 34, *etc.*

Thus, the charged particle microscope M shown in Fig. 1 comprises a charged particle optical column O for directing a charged particle beam B onto a sample; a sample holder H for holding a sample S; and a charged particle detector 22a, 22b, 30, 32, 34 with an imaging system 200 for generating an image signal based on information from the charged particle detector.

Now turning to Fig. 2, an embodiment of the charged particle microscope M including more details of the charged particle detector D and imaging system 200 as disclosed herein are shown. It is noted that generally, the detector D can be any one of TEM camera 30, STEM camera 32, spectroscopic detector 34 or segmented detector 22 as shown in Fig. 1, or any other charged particle detector in general, as long as the detector is suitable to be used in acquiring a tilt series of images.

Similar to Fig. 1, the charged particle microscope M comprises a detector D, which includes a detector chip 31. Raw data coming from that detector chip 31 is sent to an input interface 100 of imaging system 200. The imaging system 200 is arranged to generate an image signal based on information from the charged particle detector D.

As shown in Fig. 2, said imaging system 200 generally comprises an input interface 100 for receiving data, and a first charged particle detector output interface 101 for outputting a first data stream of data related to said charged particle detector D, as well as a second charged particle detector output interface 102 for outputting a second data stream of data related to said charged particle detector D.

In Fig. 2, the first charged particle detector output interface 101 is arranged for transferring data to storage 300. The connection from detector D, via imaging system 200, to storage 300 is used for storing high quality images from the sample. Here, the set-up of the first data stream is such that data quality and reliability are prioritized, ensuring accurate and dependable data output to storage 300 (i.e. maintaining the high image quality standard that present day charged particle microscopes are known for).

The imaging system also comprises a second charged particle detector output interface 102. The second charged particle detector output interface 102 is arranged for providing a different output compared to the first output interface 101. In particular, the second charged particle detector output interface 102 is arranged for providing low latency output to feedback data processing device 400, which in turn is connected to microscope M. Hence, a feedback control loop is established which can be used for feedback control applications, such as active image-based drift compensation, continuous tilt tomography field-of-view correction, or system state measurement methods.

Imaging system 200 comprises, in the embodiment shown, a data processing unit 99 that is arranged for processing so called "raw" data coming from detector chip 31. It is noted that this processing unit 99 may be part of the detector D itself, and thus the imaging system 200 may comprise a part of the detector D too. Other arrangements are conceivable as well.

After the initial processing that is done by processing unit 99, the signal may be split into two different streams.

One stream is connected to the first charged particle detector output interface 101, and includes a storage representation module 201 and a buffer 211. The storage representation module 201 and the buffer 211 are arranged for providing high quality image data from the detector D to the storage 300, substantially without loss of any image information.

One other stream is connected to the second charged particle detector output interface 102 and includes low latency representation module 202. The low latency representation module 202 is arranged to process the signal coming from the detector D (and optionally processed by data processing unit 99), and provide them to second charged particle detector output interface 102. From there, they can be forwarded to feedback data processing device 400, where additional processing for enabling real-time feedback to charged particle microscope M may take place. This enables low-latency feedback to be provided to charged particle microscope M, which may include stage moves and/or optics changes.

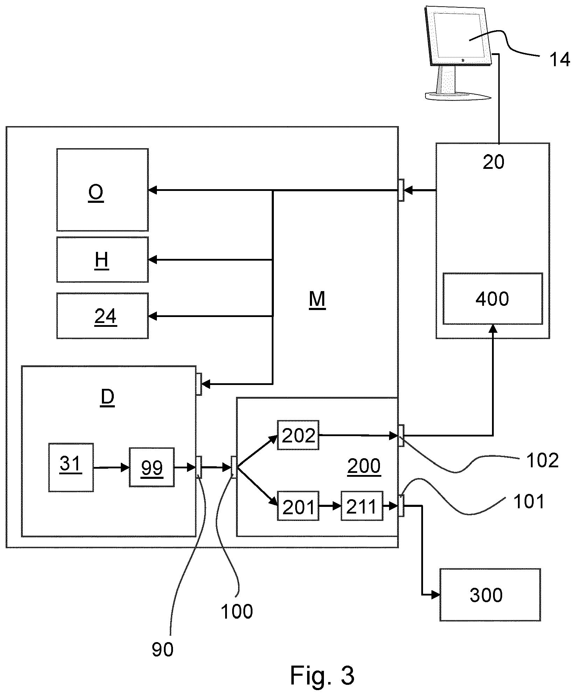

Fig. 3 shows a further embodiment of the charged particle microscope M with the imaging system 200 as disclosed herein. Here, the detector D comprises a camera chip 31 and a data processing unit 99. The data processing unit 99 is arranged for performing fast "essential" processing, which may include gain corrections and electron counting in case where the detector D is an electron detector. That processing will normally be done with a low latency. The resulting information is sent from detector D, through output 90 towards input interface 100 of imaging system 200. In imaging system 200, the data is split into two different representation blocks 201, 202. These 201, 202 may be arranged for converting the data into desired output-specific representation. These blocks 201, 202 may contain additional processing steps as well as data augmentation steps based on other information sources such as system clocks. For example, if the user chooses dose fraction storage, the storage representation block 201 will create dose fraction images, while the low-latency representation block 202 could output an Electron Event Representation stream (streams of electron event positions (x,y,time)), while embedding extra timing information such as synchronized time stamps. The storage representation 201 is buffered in block 211 to ensure no data is lost if e.g. the connection to the storage 300 gets shortly interrupted. The low-latency representation 202 is transmitted without buffering (or at least no large buffering) to prevent adding extra latency.

This low latency representation module 202 may, in an embodiment, run independently from the earlier mentioned storage representation module 201. The low latency representation module 202 is preferably optimized for low latency, while reliability of the data is a lower priority: this means that it is allowed to miss small portions of the data, as long as this is detectable.

A specific type of detector D of interest is an electron counting camera: in this case the electron counting algorithm is the key algorithm. The type of data on the output data interfaces 201 can be image "movies" (called dose fractions) or streams of electron event positions (x,y,time), which are also known as Electron Event Representation (EER). Providing EER data on the low latency output data interface 202 allows low latency event-based processing for low-dose applications. Under low-dose conditions, low-latency EER data will lead to the best possible performance in the use-cases mentioned above.

Turning back to Fig. 3, it is shown that the low latency representation module 202 may be connected to feedback data processing device 400, which, in the embodiment shown, is part of controller/processor 20. It will be clear to those skilled in the art that feedback data processing device 400 may be a separate controller/processor as well. From here, the controller/processor 20 is able to provide feedback to the charged particle microscopes M (as shown in Fig. 1 for example) by changing settings/parameters to one or more of the optical column O, the sample holder H, the imaging system 24 and/or charged particle detector D (which may be any one of 22a, 22b, 30, 32, 34 as shown in Fig. 1). Feedback data processing device 400, together with low latency representation module 202 thus allows real-time feedback to be supplied to the charged particle microscope M.

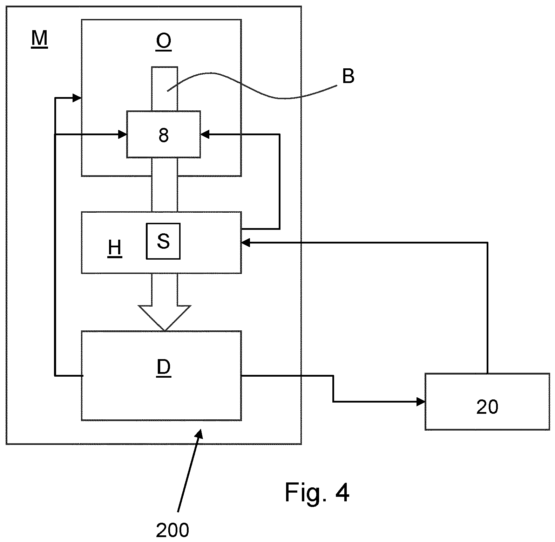

Fig. 4 shows a schematic view of an embodiment of the charged particle microscope M, including controller/processor 20, with which a tilt series of images as defined herein can be obtained. Like the embodiments of the charged particle microscopes as shown in Fig. 1-3, the charged particle microscope M shown in Fig. 4 comprises a charged particle optical column O for directing a charged particle beam B onto a sample S; a sample holder H for holding a sample S; and a charged particle detector D with an imaging system 200 for generating an image signal based on information from the charged particle detector. The charged particle microscope is arranged for obtaining a tilt series of images based on exposure of a region of interest (ROI) of a sample to said charged particle beam (CPB) at a plurality of tilt angles. The holder H is arranged for tilting the sample S for providing the plurality of tilt angles, as is known to those skilled in the art. The charged particle microscope M is arranged for tracking a field of view (FOV) of the region of interest. Images obtained with the microscope M can be used for producing a tomographic image of a sample volume related to said region of interest based on at least some images of the obtained tilt series.

Detector D provides images to controller 20, which can then be used as feedback to the microscope M to modify the holder (position, angle, etcetera) to ensure that the region of interest is within the field of view. Detector D can be synchronized to the optical column O, and/or to a blanker/deflector 8 that is part of the optical column O. The low latency possibilities of the detector D and imaging system 200 as described herein aid in the feedback low that is shown in Fig. 4.

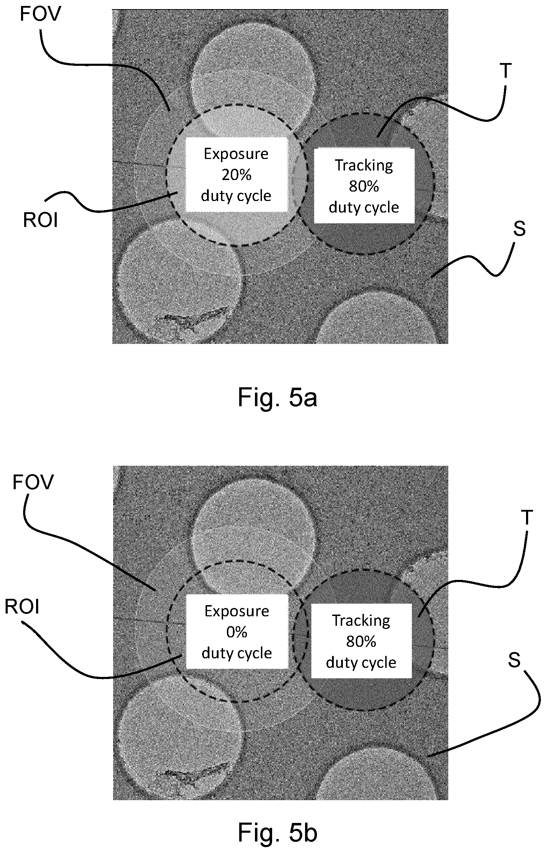

An embodiment of the tracking of the field of view FOV of the region of interest ROI is shown in Fig. 5a and 5b. Here, use is made of the tracking region, for which it can be seen that the tracking region T lies substantially outside of the region of interest ROI of the sample S.

Fig 5a shows an acquisition step for acquiring a tilt series image. A tilt series image is typically acquired as a movie of frames that are later post-processed to yield a single image. Thus, multiple frames are acquired at the region of interest, which gives the opportunity to interleave these frames with tracking frames. During this acquisition of the tilt series the beam B may alternatingly expose the region of interest ROI and the tracking region T. In the embodiment shown, exposure of the region of interest ROI has a duty cycle of 20%, and exposure of the tracking region has a duty cycle of 80%. In other words, the region of interest is exposed for approximately 20% of the time, and the tracking region is exposed for the remaining 80% of the time. The 20% and 80% may refer to the total frames acquired during the acquisition.

The numbers above are an example of how to distribute the dose to exposure and tracking. You can either use 20% of frames for exposure and 80% of frames for tracking ("slow mode"), or 20% of the frame time in even frames for exposure and 80% of the frame time in odd frames for tracking ("fast mode"), as shown in Fig. 5a.

In so called slow mode it's possible to acquire one frame at exposure and four frames at tracking, i.e., the overall period is (one plus four=) five frames.

In fast mode, it's possible to take 20% of a first frame for exposure, and to take 80% of a second frame for tracking. Thus, each frame a switch takes place. With the exact same timings, it's then possible to switch to "no exposure", e.g., during tilting, by simply blanking the beam when there would be exposure (Fig. 5b). The same can be achieved with the deflector, but it's more practical to keep the deflector signal constant and just activate the (pre-programmed) blanker signal.

In an embodiment (not shown) it's possible to use the "fast mode" as described above and slightly modify it as follows using a blanker. Here the blanker can be used to unblank the charged particle beam only for a short time window within a frame when there is no frame readout going on. The detector may be arranged for adding a short "no readout" time to each frame time. This slightly lowers the frame rate to enable "clean" exposure. If this is not done, then some lines will be exposed but still counted towards the "old" frame, resulting in frames "blurring into each other in time".

Fig. 5b shows a step wherein (after acquisition of a tilt angle according to Fig. 5a) the tilt angle is changed to a new angle (i.e. no tilt series image is being acquired, but the microscope is being set up for acquiring a new tilt series image). Here, the tracking region T is still being exposed to the charged particle beam, whereas the region of interest ROI is not exposed at all. It is possible that the region of interest ROI is free from being exposed by means of blanking and/or deflecting the charged particle beam B. To this end, the deflector or blanker 8 may be used, which is known to those skilled in the art.

Thus, in Fig. 5a and 5b an exposure of the tracking region T is performed during the acquisition of the tilt series image and during preparation of the next tilt series image, i.e. during manipulation of the stage H to move to another stage angle. This allows the tracking region to be used for tracking the field of view FOV and to align the region of interest with the beam B of the charged particle microscope M. Thus, the field of view can be aligned and corrected during the acquisition of the tilt series.

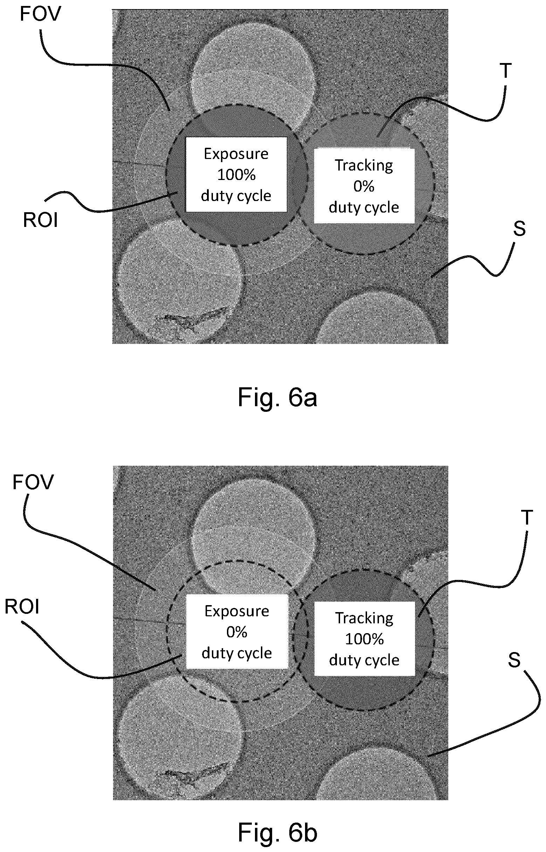

Fig. 6a and 6b show an alternative embodiment, which mainly differs in the way the beam is used during exposure of the region of interest ROI for acquiring a tilt series image. Here, the region of interest ROI is exposed to the beam B during acquisition of a tilt series image. Whilst the region of interest ROI is exposed, the tracking region is not exposed, i.e. is free from being exposed by the charged particle beam. After sufficient exposure of the region of interest ROI, the beam is then moved by a pre-determined amount (using deflectors 8) to ensure the beam is exposing the tracking region T. Then, the tracking region is being tracked during manipulation of the stage H during movement to the next tilt angle (Fig. 6b). This allows the tracking region T to be used for tracking the field of view FOV of the region of interest ROI, and allows modifications to the stage H and/or beam B to be made for keeping the field of view in the correct region of interest.

In Fig. 6a and 6b the region of interest ROI and the tracking region T are alternatingly exposed. The region of interest ROI during the acquisition of the tilt series image, and the tracking region T during the tilt. This is, in principle the simplest version, which can be realized without needing a fast deflector or blanker.

In principle, there are three scenarios for establishing exposure of the region of interest ROI whilst keeping track of the tracking region T.

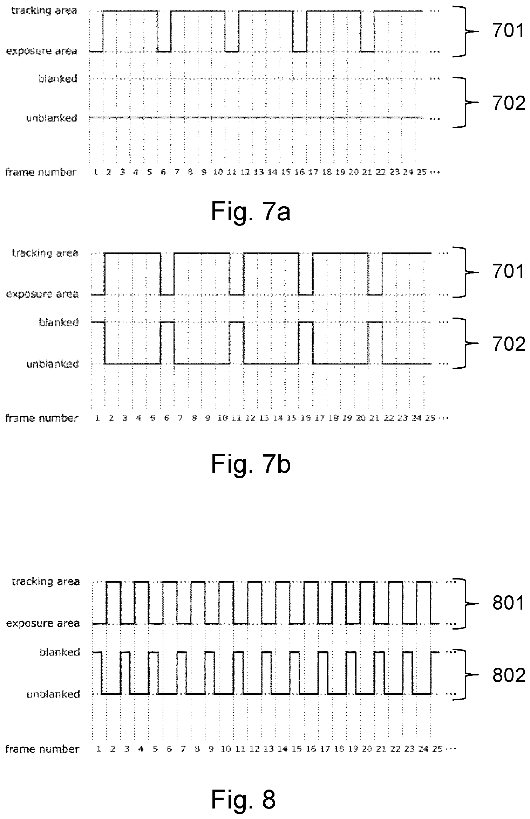

Scenario A (Fig. 7a and 7b): The simplest way to realize the situations as in the example in Fig. 5 is to synchronize the blanker 8 with the camera D and to distribute the frames 1:4 between exposure and tracking regions. The deflector and blanker signals are shown in Fig. 7a and 7b. Fig. 7a shows the deflector 701 and blanker 702 signals during acquisition, and Fig. 7b shows the deflector 701 and blanker signals 702 during tilting. The beam B simply switches between areas ROI, T and is blanked at the region of interest ROI during tilt. This is the situation as shown in Fig. 6a and 6b.

Scenario B (Fig. 8): To allow faster acquisition, the beam can instead be switched at every frame, and the blanker 8 is used to reduce the duty cycle at the exposure area to 20 %. Faster acquisition with same duty cycles (20 % exposure, 80 % tracking). During tilt, the blanker switches from 20 % to 0 % duty cycle at the exposure area, see deflector 801 and blanker 802 signals in Fig. 8.

Scenario C: During acquisition, the beam is kept at the exposure area. This allows to use all camera frames (instead of every second frame) during exposure, improving time resolution. It requires switching the deflector signal to constant (not depicted in any figure), so that both the region of interest ROI and the tracking region T are imaged at the same time.

It is remarked that the duty cycles indicated in Fig. 6-8 and described in scenarios A, B C are shown to add up to 100%, but this is not necessary. For example, at the region of interest ROI, a duty cycle of only 1 % can be used (i.e. stroboscopic illumination).

It is furthermore remarked that scenarios A and B can be combined, for example by varying 5 independent parameters:
(1) slow (across-frame) period length
(2) slow duty cycles of the region of interest ROI;
(3) slow duty cycle of the tracking region T;
(4) fast (within-frame) duty cycle for the region of interest ROI;
(5) fast (within-frame) duty cycle for tracking region.

From the description above it will be understood that the charged particle microscope M is arranged for, and the method as described herein includes, tracking the field of view (FOV) during the step of obtaining the tilt series of images by exposing a tracking region that is substantially outside of said region of interest (ROI). The step of obtaining the tilt series of images comprises an exposure step of exposing the region of interest for acquiring a tilt series image, and a tilt step of tilting the sample to a new tilt angle. It is thus to be understood that "during the step of obtaining the tilt series of images" may include exposing the tracking region T in between successive exposures of the region of interest ROI at two different tilt angles. It is further to be understood that "during the step of obtaining the tilt series of images" may also include exposing the tracking region T during the tilt step of tilting the sample to a new tilt angle.

The method and charged particle microscope M as described herein allow for the field of view FOV to be reliably tracked without any overhead.

The technique can be used for tilt tomography and continuous tilt tomography.

## Claims

1. A method, comprising:
- obtaining a tilt series of images based on exposure of a region of interest (ROI) of a sample to a charged particle beam (CPB) at a plurality of tilt angles;
- tracking a field of view (FOV) of the region of interest;
**Characterized in that** said step of tracking said field of view (FOV) is performed during the step of obtaining the tilt series of images and comprises exposing a tracking region that is substantially outside of the region of interest (ROI).

2. Method according to claim 1, comprising the step of deflecting said charged particle beam between said region of interest and said tracking region.

3. Method according to claim 2, wherein a ratio between exposure of the region of interest and exposure of the tracking region is in between 1:2 to 1:10, more in particular around 1:4.

4. Method according to claim 1-3, wherein said tracking region is completely separate from said region of interest.

5. Method according to claim 1-4, comprising the step of using images of said tracking region for determining the shift in field of view of said region of interest.

6. Method according to claim 1-5, comprising the step of using said field of view of said tracking region for providing a feedback loop during the step of obtaining the tilt series of images of the region of interest.

7. Method according to claim 1-6, comprising the step of using a blanker for at least partly preventing exposure to said region of interest during said step of exposing said tracking region.

8. Method according to claim 1-7, comprising the step of correcting said field of view by moving the sample relative to the charged particle beam.

9. Method according to claim 1-8, wherein said method comprises step-by-step tomography or continuous tilt tomography.

10. A charged particle microscope, comprising:
- a charged particle optical column for directing a charged particle beam onto a sample;
- a sample holder for holding a sample; and
- a charged particle detector and an imaging system for generating an image signal based on information from the charged particle detector;
Wherein said charged particle microscope is arranged for
- obtaining a tilt series of images based on exposure of a region of interest (ROI) of a sample to said charged particle beam (CPB) at a plurality of tilt angles;
- tracking a field of view (FOV) of the region of interest (ROI);
**Characterized in that said** charged particle microscope M is arranged for tracking the field of view (FOV) during the step of obtaining the tilt series of images by exposing a tracking region that is substantially outside of said region of interest (ROI).

11. Charged particle microscope M according to claim 10, and arranged for performing the method as defined in claim 1-9.
